# EUROPEAN PATENT SPECIFICATION

(11) **EP 3 907 308 B1**
(45) Date of publication and mention of the grant of the patent: **12.02.2025**
(21) Application number: 19926234.6
(22) Date of filing: 30.12.2019
(51) Int. Cl.: H01L 21/687, C23C 16/458, C23C 16/44, C23C 16/46, C30B 25/12

(54) **WAFER CARRIER FOR METAL ORGANIC CHEMICAL VAPOR DEPOSITION**
WAFERTRÄGER ZUR METALLORGANISCHEN CHEMISCHEN GASPHASENABSCHEIDUNG
SUPPORT DE TRANCHE POUR DÉPÔT CHIMIQUE EN PHASE VAPEUR ORGANOMÉTALLIQUE

(30) Priority: 22.04.2019 CN 201910324680
(43) Date of publication of application: 10.11.2021
(73) Proprietor: Huawei Technologies Co., Ltd., Shenzhen, Guangdong 518129 (CN)
(72) Inventor: PENG, Zetao, Shenzhen, Guangdong 518129 (CN); WAN, Yuxi, Shenzhen, Guangdong 518129 (CN)
(74) Representative: Gill Jennings & Every LLP
(86) International application number: PCT/CN2019/129974
(87) International publication number: WO 2020/215790

(56) References cited:
- CN-A- 103 938 186
- CN-A- 104 047 051
- CN-A- 104 047 051
- CN-A- 104 051 316
- CN-A- 104 051 316
- CN-A- 110 129 768
- US-A1- 2010 037 827
- US-A1- 2016 201 219

## Description

This application claims priority to Chinese Patent Application No. 201910324680.5, filed with the China National Intellectual Property Administration on April 22, 2019 and entitled "WAFER CARRIER FOR METAL ORGANIC CHEMICAL VAPOR DEPOSITION", which is incorporated herein by reference in its entirety.

### TECHNICAL FIELD

This application relates to the field of semiconductor technologies, and in particular, to a wafer carrier for metal organic chemical vapor deposition.

### BACKGROUND

Metal organic chemical vapor deposition (Metal Organic Chemical Vapor Deposition, MOCVD) devices are widely used in light emitting diode (Light Emitting Diode, LED) epitaxy (Epitaxy) and device epitaxy. An MOCVD device includes a wafer carrier (Wafer Carrier), and a plurality of wafer sub-carriers are distributed on the wafer carrier. The wafer sub-carrier is configured to place the epitaxial wafer substrate. An LED epitaxial growth process using MOCVD usually includes the following steps: An epitaxial wafer substrate is placed on a wafer sub-carrier. The substrate and the wafer sub-carrier are heated to 500°C to 1200°C by a resistance wire or radio frequency. An organic source is brought into a reaction chamber through carrier gases H₂, N₂, and the like, and grows on the epitaxial wafer substrate to form a thin film. As technologies advance, a size of the epitaxial wafer substrate becomes larger (6 inches, 8 inches, and 12 inches), increasing stress and warpage of an epitaxial wafer. As the stress and warpage of the epitaxial wafer increase, crystal quality of a flat edge and a border of the epitaxial wafer is greatly affected.

CN 104047051 discloses a graphite bearing plate for processing LED epitaxial wafer. CN 103938186 discloses a tray, MOCVD reaction chamber and MOCVD device. CN 104051316 discloses a graphite bearing tray capable of regulating and controlling local temperature field. US 2017/0201219 A1 relates to a susceptor for a reactor for epitaxial growth.

### SUMMARY

Embodiments of this application provide a wafer carrier for metal organic chemical vapor deposition, to improve crystal quality of a flat edge or a border of an epitaxial wafer. The invention is defined by the appended claims. Embodiments not falling within the scope of the claims are for illustration only.

According to a first aspect, an embodiment of this application provides a wafer carrier for metal organic chemical vapor deposition, including at least one wafer sub-carrier that is in a groove structure and that is configured to place an epitaxial wafer substrate. A thermal conductivity of a side wall (1022) of the wafer sub-carrier is higher than a thermal conductivity of a bottom wall (1021) of the wafer sub-carrier.

A first space in the wafer sub-carrier is filled with a first thermally conductive material. The first space is a space between a flat edge of the epitaxial wafer substrate and a side wall of the wafer sub-carrier when the epitaxial wafer substrate is placed on the wafer sub-carrier. A thermal conductivity of the first thermally conductive material is not lower than a thermal conductivity of the wafer sub-carrier.

With reference to the first aspect, in a first possible implementation of the first aspect, a height of the first thermally conductive material filled in the first space is not higher than a height of the side wall of the wafer sub-carrier.

In this implementation, a risk of the first thermally conductive material being thrown off due to rotation of the wafer carrier and rotation of the wafer sub-carrier can be avoided.

With reference to the first aspect, in a second possible implementation of the first aspect, a material of the wafer sub-carrier is graphite, and the first thermally caonductive material is any one or a combination of at least two of the following:
graphite, silicon carbide, graphene, titanium metal, and tungsten metal.

In this implementation, the first thermally conductive material is selected for the material of the wafer sub-carrier, so that a thermal radiation heating effect at a position of the flat edge of the epitaxial wafer substrate can be improved, and crystal quality of a flat edge of the epitaxial wafer is improved, thereby improving an overall yield of the epitaxial wafer.

With reference to the second possible implementation of the first aspect, in a third possible implementation of the first aspect, a surface of the wafer sub-carrier is coated with silicon carbide, and a surface of the first thermally conductive material filled in the first space is coated with silicon carbide.

In this implementation, strength and hardness of the surface of the wafer sub-carrier and the surface of the first thermally conductive material filled in the first space can be increased, and gas corrosion can be mitigated.

In this implementation, a thermal radiation heating effect at a position of a border of the epitaxial wafer substrate can be improved, and a temperature at the position of the border of the epitaxial wafer substrate is compensated for, so that generation of defects such as black spots, blurred edges, and cracks on a border of an epitaxial wafer is avoided, and crystal quality of a border of the epitaxial wafer is improved, thereby improving an overall yield of the epitaxial wafer.

With reference to the fourth possible implementation of the first aspect, in a fifth possible implementation of the first aspect, a material of the bottom wall of the wafer sub-carrier is graphite, and a material of the side wall of the wafer sub-carrier is graphene.

In this implementation, the first thermally conductive material is selected for the material of the bottom wall of the wafer sub-carrier, so that a thermal radiation heating effect at a position of the flat edge of the epitaxial wafer substrate can be improved, and crystal quality of a flat edge of an epitaxial wafer is improved, thereby improving an overall yield of the epitaxial wafer.

With reference to the fourth possible implementation of the first aspect, in a sixth possible implementation of the first aspect, the side wall of the wafer sub-carrier includes a first layer and a second layer, and a thermal conductivity of the second layer is higher than the thermal conductivity of the bottom wall of the wafer sub-carrier.

In this implementation, the side wall of the wafer sub-carrier includes a high thermal conductivity layer whose thermal conductivity is higher than the thermal conductivity of the bottom wall of the wafer sub-carrier, so that a thermal radiation heating effect at a position of a border of the epitaxial wafer substrate can be improved, and a temperature at the position of the border of the epitaxial wafer substrate can be compensated for.

With reference to the sixth possible implementation of the first aspect, in a seventh possible implementation of the first aspect, the second layer includes a second thermally conductive material attached to an inner periphery of the first layer, and a thermal conductivity of the second thermally conductive material is higher than the thermal conductivity of the bottom wall of the wafer sub-carrier.

In this implementation, the second thermally conductive material is attached to the inner periphery of the first layer, to form the second layer. A process flow is simple and easy to operate. In addition, the existing wafer sub-carrier can be modified to obtain a wafer sub-carrier capable of compensating for the temperature at the position of the border of the epitaxial wafer substrate.

With reference to the sixth possible implementation of the first aspect, in an eighth possible implementation of the first aspect, a material of the second layer is graphene, a material of the first layer is graphite, and a material of the bottom wall of the wafer sub-carrier is graphite.

In this implementation, the material of the second layer is selected for the material of the bottom wall of the wafer sub-carrier and the material of the first layer of the side wall, so that a thermal radiation heating effect at a position of a border of the epitaxial wafer substrate can be improved, and crystal quality of a border of an epitaxial wafer is improved, thereby improving an overall yield of the epitaxial wafer.

With reference to the first aspect, in a ninth possible implementation of the first aspect, the wafer carrier is a graphite carrier, and the wafer sub-carrier is a groove on the graphite carrier.

In this implementation, filling of the first thermally conductive material becomes easier, production efficiency is improved, and a process flow is simple.

With reference to the first aspect, in a tenth possible implementation of the first aspect, the wafer carrier is a large graphite carrier, and the wafer sub-carrier is a small graphite carrier disposed on the large graphite carrier.

In this implementation, filling of the first thermally conductive material becomes easier, production efficiency is improved, and a process flow is simple.

With reference to the first aspect, in an eleventh possible implementation of the first aspect, a diameter of the epitaxial wafer is greater than or equal to 6 inches.

In this implementation, an overall yield of a large-sized epitaxial wafer can be improved.

According to a second aspect, a wafer carrier for metal organic chemical vapor deposition is provided, including at least one wafer sub-carrier that is in a groove structure and that is configured to place an epitaxial wafer substrate. The wafer sub-carrier has a side wall whose thermal conductivity is higher than a thermal conductivity of a bottom wall of the wafer sub-carrier.

With reference to the second aspect, in a first possible implementation of the second aspect, a material of the bottom wall of the wafer sub-carrier is graphite; and a material of the side wall of the wafer sub-carrier is graphene.

In this implementation, the first thermally conductive material is selected for the material of the bottom wall of the wafer sub-carrier, so that a thermal radiation heating effect at a position of a flat edge of the epitaxial wafer substrate can be improved, and crystal quality of a flat edge of an epitaxial wafer is improved, thereby improving an overall yield of the epitaxial wafer.

With reference to the second aspect, in a second possible implementation of the second aspect, the side wall of the wafer sub-carrier includes a first layer and a second layer, and a thermal conductivity of the second layer is higher than the thermal conductivity of the bottom wall.

In this implementation, the side wall of the wafer sub-carrier includes a high thermal conductivity layer whose thermal conductivity is higher than the thermal conductivity of the bottom wall of the wafer sub-carrier, so that a thermal radiation heating effect at a position of a border of the epitaxial wafer substrate can be improved, and a temperature at the position of the border of the epitaxial wafer substrate can be compensated for.

With reference to the second possible implementation of the second aspect, in a third possible implementation of the second aspect, the second layer includes a second thermally conductive material attached to an inner periphery of the first layer, and a thermal conductivity of the second thermally conductive material is higher than the thermal conductivity of the bottom wall of the wafer sub-carrier.

In this implementation, the second thermally conductive material is attached to the inner periphery of the first layer, to form the second layer. A process flow is simple and easy to operate. In addition, the existing wafer sub-carrier can be modified to obtain a wafer sub-carrier capable of compensating for the temperature at the position of the border of the epitaxial wafer substrate.

With reference to the third possible implementation of the second aspect, in a fourth possible implementation of the second aspect, the wafer carrier is a graphite carrier, the wafer sub-carrier is a groove on the graphite carrier, and the second thermally conductive material is graphene.

In this implementation, filling of the second thermally conductive material can be facilitated, production efficiency is improved, and a process flow is simple. In addition, the material of the second layer is selected for the material of the wafer sub-carrier, so that a thermal radiation heating effect at a position of a border of the epitaxial wafer substrate can be improved, crystal quality at a border of an epitaxial wafer is improved, and an overall yield of the epitaxial wafer is improved. In addition, a gap between the wafer sub-carrier and the epitaxial wafer substrate is filled by the second thermally conductive material, so that the epitaxial wafer substrate is more stable in the wafer sub-carrier, and a risk of flying pieces caused by a centrifugal force generated due to rotation of the wafer carrier or rotation of the wafer sub-carrier is reduced.

With reference to the second possible implementation of the second aspect, in a fifth possible implementation of the second aspect, a material of the second layer is graphene, a material of the first layer is graphite, and a material of the bottom wall of the wafer sub-carrier is graphite.

In this implementation, the material of the second layer is selected for the material of the bottom wall of the wafer sub-carrier and the material of the first layer of the side wall, so that a thermal radiation heating effect at a position of a border of the epitaxial wafer substrate can be improved, and crystal quality of a border of an epitaxial wafer is improved, thereby improving an overall yield of the epitaxial wafer.

With reference to the second aspect, in a sixth possible implementation of the second aspect, a first space in the wafer sub-carrier is filled with a first thermally conductive material. The first space is a space between a flat edge of the epitaxial wafer substrate and the side wall of the wafer sub-carrier when the epitaxial wafer substrate is placed on the wafer sub-carrier. A thermal conductivity of the first thermally conductive material is not lower than a thermal conductivity of the wafer sub-carrier.

In this implementation, a thermal radiation heating effect at a position of the flat edge of the epitaxial wafer substrate can be improved, and a temperature at the position of the flat edge of the epitaxial wafer substrate is compensated for, so that generation of defects such as black spots, blurred edges, and cracks on a border of an epitaxial wafer is avoided, and crystal quality of a flat edge of the epitaxial wafer is improved, thereby improving an overall yield of the epitaxial wafer.

With reference to the sixth possible implementation of the second aspect, in a seventh possible implementation of the second aspect, a height of the first thermally conductive material filled in the first space is not higher than a height of the side wall of the wafer sub-carrier.

In this implementation, a risk of the first thermally conductive material being thrown off due to rotation of the wafer carrier and rotation of the wafer sub-carrier can be avoided.

With reference to the sixth possible implementation of the second aspect, in an eighth possible implementation of the second aspect, a material of the wafer sub-carrier is graphite; and the first thermally conductive material is any one or a combination of at least two of the following:
graphite, silicon carbide, graphene, titanium metal, and tungsten metal.

In this implementation, the first thermally conductive material is selected for the material of the wafer sub-carrier, so that a thermal radiation heating effect at a position of the flat edge of the epitaxial wafer substrate can be improved, and crystal quality of a flat edge of the epitaxial wafer is improved, thereby improving an overall yield of the epitaxial wafer.

With reference to the eighth possible implementation of the second aspect, in a ninth possible implementation of the second aspect, a surface of the wafer sub-carrier is coated with silicon carbide, and a surface of the first thermally conductive material filled in the first space is coated with silicon carbide.

In this implementation, strength and hardness of the surface of the wafer sub-carrier and the surface of the first thermally conductive material filled in the first space can be increased, and gas corrosion can be mitigated.

With reference to the second aspect, in a tenth possible implementation of the second aspect, the wafer carrier is a large graphite carrier, and the wafer sub-carrier is a small graphite carrier disposed on the large graphite carrier.

In this implementation, filling of the first thermally conductive material becomes easier, production efficiency is improved, and a process flow is simple.

With reference to the second aspect, in an eleventh possible implementation of the second aspect, a diameter of the epitaxial wafer is greater than or equal to 6 inches.

In this implementation, an overall yield of a large-sized epitaxial wafer can be improved.

According to the wafer carrier provided in the embodiments of this application, the thermal radiation heating effect at the position of the flat edge or the border of the epitaxial wafer substrate can be improved, and the temperature at the position of the flat edge or the border of the epitaxial wafer substrate can be compensated for, so that a temperature of the entire epitaxial wafer substrate can be more even. In this way, the generation of defects such as black spots, blurred edges, and cracks on the flat edge or the border of the epitaxial wafer is avoided, the crystal quality of the flat edge of the epitaxial wafer is improved, and the overall yield of the epitaxial wafer is improved.

### BRIEF DESCRIPTION OF DRAWINGS

FIG. 1 is a schematic structural diagram of a wafer carrier according to an embodiment of this application;
FIG. 2 is a schematic structural diagram of a wafer carrier according to an embodiment of this application;
FIG. 3 is a schematic structural diagram of a wafer sub-carrier according to an embodiment of this application;
FIG. 4 is a schematic structural diagram of a wafer sub-carrier according to an embodiment of this application;
FIG. 5 is a schematic structural diagram of a wafer sub-carrier according to an embodiment of this application;
FIG. 6 is a schematic structural diagram of a wafer sub-carrier according to an embodiment of this application; and
FIG. 7 is a schematic structural diagram of a wafer carrier according to an embodiment of this application.

In the figures: 100. Wafer carrier; 101. Shaft hole; 102. Wafer sub-carrier; 103. Epitaxial wafer substrate; 104. First space; 1021. Wafer sub-carrier bottom wall; 1022. Wafer sub-carrier side wall; 10221. First layer; 10222. Second layer.

### DESCRIPTION OF EMBODIMENTS

The following describes technical solutions of embodiments in this application with reference to accompanying drawings. Apparently, the described embodiments are merely some but not all of the embodiments of this application. In addition, it should be noted that, in the embodiments of this application, unless otherwise specified, "a plurality of means two or more.

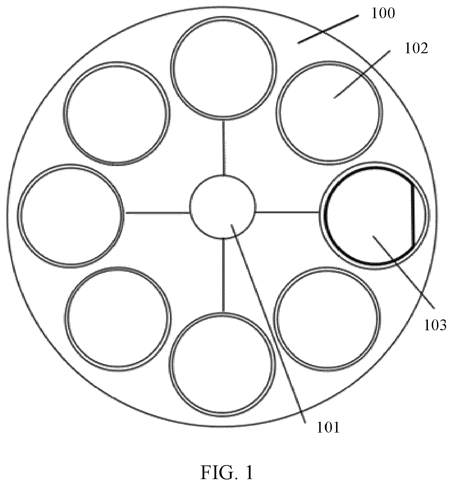

FIG. 1 shows a wafer carrier for metal organic chemical vapor deposition. As shown in FIG. 1, a center of the wafer carrier is a shaft hole 101. In a growing process of an epitaxial wafer, the wafer carrier 100 can rotate at a high speed driven by a rotating shaft corresponding to the shaft hole 101. A plurality of wafer sub-carriers 102 are distributed on the wafer carrier 100, and the plurality of wafer sub-carriers 102 are arranged on the wafer carrier along a loop. The loop passes through centers of the wafer sub-carriers 102 and is in a concentric relationship with an outer periphery of the wafer carrier.

The wafer sub-carrier 102 is in a groove structure and is configured to place the epitaxial wafer substrate 103. The wafer carrier 100 may be a large graphite carrier, and the wafer sub-carrier 102 may be a small graphite carrier. A surface of the large graphite carrier and a surface of the small graphite carrier are both coated with a silicon carbide material. The small graphite carrier can rotate in the growing process of the epitaxial wafer.

The small graphite carrier is usually circular, and when an epitaxial wafer substrate is placed on the small graphite carrier, a relatively large gap is left between a flat edge of the epitaxial wafer substrate and a side wall of the small graphite carrier. During growth of the epitaxial wafer, because an airflow of a carrier gas can quickly take away heat, a temperature at a position of the flat edge of the epitaxial wafer substrate is lower than a temperature at a position of a center of the epitaxial wafer substrate. In other words, a flat edge and a center of the epitaxial wafer may be unevenly heated. Consequently, crystal quality of the flat edge of epitaxial wafer is poor, and a large quantity of defects such as black spots, blurred edges, and cracks occur.

In addition, for epitaxial wafer substrates of larger sizes (for example, 6 inches, 8 inches, and 12 inches), warpage of an epitaxial wafer grown on the epitaxial wafer substrate is relatively large. Consequently, a border of the epitaxial wafer is warped by a particular height, causing a temperature of the border of the epitaxial wafer to be lower than that of a center of the epitaxial wafer, and resulting in poor crystal quality of the border of the epitaxial wafer and a large quantity of defects such as black spots, blurred edges, and cracks.

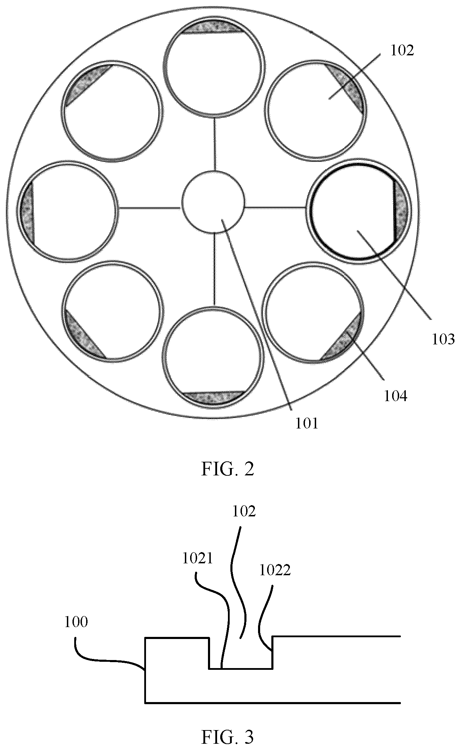

An embodiment of this application provides a wafer carrier for metal organic chemical vapor deposition. As shown in FIG. 2, the wafer carrier includes at least one wafer sub-carrier 102. The wafer sub-carrier 102 is in a groove structure and is configured to place the epitaxial wafer substrate 103.

The wafer carrier may be a graphite carrier, and the wafer sub-carrier 102 is a groove on the graphite carrier. A structure of the wafer sub-carrier 102 is shown in FIG. 3. It can be learned that the wafer sub-carrier 102 is integrally formed. Specifically, the wafer sub-carrier 102 may be formed in a form of a groove carved in the wafer carrier. The wafer sub-carrier 102 has a bottom wall 1021 and a side wall 1022.

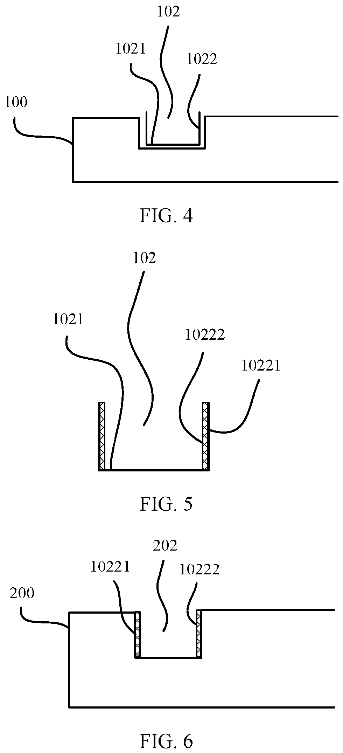

Alternatively, the wafer carrier may be a large graphite carrier, and the wafer sub-carrier 102 is a small graphite carrier disposed on the large graphite carrier. Specifically, as shown in FIG. 4, it can be learned that the wafer sub-carrier 102 and the wafer carrier are independent of each other, and the wafer sub-carrier 102 is located on the wafer carrier. In an example, the wafer sub-carrier 102 can rotate during growth of an epitaxial wafer.

The epitaxial wafer substrate 103 may be a substrate with a diameter greater than or equal to 6 inches. Specifically, the epitaxial wafer substrate 103 may be a substrate with a diameter of 6 inches, or may be a substrate with a diameter of 8 inches, or may be a substrate with a diameter of 12 inches.

As shown in FIG. 2, a first space 104 in any wafer sub-carrier 102 is filled with a first thermally conductive material. The first space 104 is a space between a flat edge of the epitaxial wafer substrate 103 and a side wall of the wafer sub-carrier 102 when the epitaxial wafer substrate 103 is placed on the wafer sub-carrier 102. A thermal conductivity of the first thermally conductive material is not lower than a thermal conductivity of the wafer sub-carrier 102. A surface that is of the first space 104 in any wafer sub-carrier 102 and that faces the flat edge of the epitaxial wafer substrate 103 is a plane. The plane is perpendicular to a radial direction of the wafer carrier. In an example, the first space 104 in any wafer sub-carrier 102 may be located on a side that is of the wafer sub-carrier 102 and that is away from a shaft hole 101.

In an example, a height of the first thermally conductive material filled in the first space 104 is not higher than a height of the side wall of the wafer sub-carrier 102.

To avoid a risk of the first thermally conductive material being thrown off due to rotation of the wafer carrier and rotation of the wafer sub-carrier 102, the height of the filled first thermally conductive material is not higher than that of the side wall of the wafer sub-carrier 202.

In a case of this example, the height of the first thermally conductive material filled in the first space 104 is equal to the height of the side wall of the wafer sub-carrier 102.

In another case of this example, the height of the first thermally conductive material filled in the first space 104 is not higher than the height of the side wall of the wafer sub-carrier 102, and is not lower than a thickness of the epitaxial wafer substrate 103.

In an example, a material of the wafer sub-carrier 102 is graphite, and the first thermally conductive material is any one or a combination of at least two of the following:
graphite, silicon carbide, graphene, titanium metal, and tungsten metal.

In a case of this example, the first thermally conductive material may be coated or bonded to the first space 104.

In another case of this example, a surface of the wafer sub-carrier 102 is coated with silicon carbide, and a surface of the first thermally conductive material filled in the first space 104 is coated with silicon carbide. Coating silicon carbide can increase strength and hardness of the surface of the wafer sub-carrier 102 and the surface of the first thermally conductive material, and can mitigate gas corrosion.

The wafer sub-carrier 102 has a side wall whose thermal conductivity is higher than a thermal conductivity of the bottom wall of the wafer sub-carrier 102.

In this example, the thermal conductivity of the side wall of the wafer sub-carrier 102 is relatively high, so that during growth of an epitaxial wafer, a thermal radiation heating effect on a border of the epitaxial wafer is better, thereby avoiding poor crystal quality at the border of the epitaxial wafer, and a large quantity of defects such as black spots, blurred edges, and cracks.

In a first case of this example, a material of the bottom wall of the wafer sub-carrier 102 may be graphite, and a material of the side wall of the wafer sub-carrier 102 is graphene.

Specifically, a structure of the wafer sub-carrier 102 may be shown in FIG. 4. The wafer sub-carrier 102 includes a bottom wall 1021 and a side wall 1022. A component material of the bottom wall 1021 is graphite, and a component material of the side wall 1022 is graphene. A surface of the bottom wall 1021 and a surface of the side wall 1022 are coated with silicon carbide, to increase strength and hardness, and to mitigate gas corrosion.

In a second case of this example, the side wall of the wafer sub-carrier includes a first layer and a second layer, and a thermal conductivity of the second layer is higher than the thermal conductivity of the bottom wall of the wafer sub-carrier.

In a specific implementation solution of the second example, the structure of the wafer sub-carrier 102 may be shown in FIG. 5. The wafer sub-carrier 102 includes a bottom wall 1021 and a side wall. The side wall includes a first layer 10221 and a second layer 10222. The second layer 10222 is made of a second thermally conductive material attached to an inner periphery of the first layer 10221. A thermal conductivity of the second thermally conductive material is higher than the thermal conductivity of the bottom wall 1021 of the wafer sub-carrier. Specifically, the second thermally conductive material may be coated or bonded to the inner periphery of the first layer 10221, to form the second layer 10222.

Composition materials of the bottom wall 1021 and the first layer 10221 may be graphite, and a composition material of the second layer 10222 may be graphene. A surface of the bottom wall 1021, a surface of the first layer 10221, and a surface of the second layer 10222 are coated with silicon carbide, to increase strength and hardness, and to mitigate gas corrosion.

In another specific implementation solution of the second example, the structure of the wafer sub-carrier 102 may be shown in FIG. 6. The wafer sub-carrier 102 is a groove of the wafer carrier, and the wafer sub-carrier 102 and the wafer carrier are integrated. The side wall of the wafer sub-carrier 102 includes a first layer 10221 and a second layer 10222. The first layer 10221 is a wall formed by a body of the wafer carrier. The second layer 10222 is made of a second thermally conductive material attached to an inner periphery of the first layer 10221. A thermal conductivity of the second thermally conductive material is higher than the thermal conductivity of the bottom wall 1021 of the wafer sub-carrier. Specifically, the second thermally conductive material may be coated or bonded to the inner periphery of the first layer 10221, to form the second layer 10222.

A composition material of the wafer carrier may be graphite. To be specific, composition materials of the bottom wall 1021 and the first layer 10221 may be graphite, and a composition material of the second layer 10222 may be graphene. A surface of the bottom wall 1021 and a surface of the second layer 10222 are coated with silicon carbide, to increase strength and hardness, and to mitigate gas corrosion.

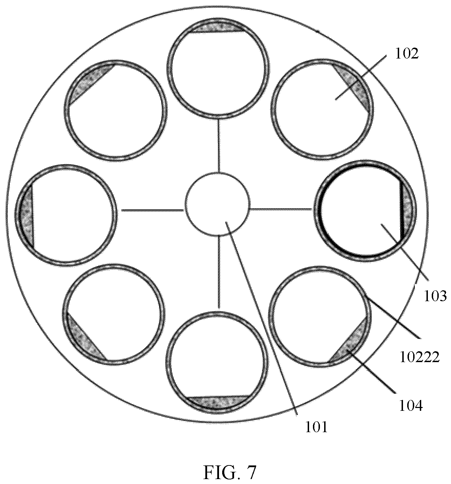

In still another specific implementation solution of the second example, referring to FIG. 7, the second layer 10222 is formed by filling a second space with a second thermally conductive material, the filled second thermally conductive material is attached to an inner periphery of the first layer, and the first layer is an original side wall of the wafer sub-carrier 102. The second layer 10222 is formed by filling the second thermally conductive material, and the second layer 10222 and the first layer together form a new side wall of the wafer sub-carrier 102. A thermal conductivity of the first layer of the wafer sub-carrier 102 is the same as the thermal conductivity of the bottom wall of the wafer sub-carrier 102, and a thermal conductivity of the second thermally conductive material is higher than the thermal conductivity of the bottom wall of the wafer sub-carrier 102, so that a thermal conductivity of the new side wall is higher than the thermal conductivity of the bottom wall. A gap between the wafer sub-carrier and the epitaxial wafer substrate is filled with the second thermally conductive material, so that the epitaxial wafer substrate is more stable in the wafer sub-carrier, thereby reducing a risk of flying pieces caused by a centrifugal force generated due to rotation of the wafer carrier or rotation of the wafer sub-carrier.

Materials of the first layer and the bottom wall may be graphite, and the second thermally conductive material may be graphene. A surface of the second layer 10222 and a surface of the bottom wall are coated with silicon carbide, to increase strength and hardness, and to mitigate gas corrosion.

In a third case of this example, the first thermally conductive material and the second thermally conductive material may be the same, for example, both may be graphene, and may be filled at the same time during filling, thereby improving production efficiency, and a process flow is simple.

According to the wafer carrier provided in this embodiment of this application, the thermal radiation heating effect at the position of the flat edge or the border of the epitaxial wafer substrate can be improved, and the temperature at the position of the flat edge of the epitaxial wafer substrate can be compensated for, so that a temperature of the entire epitaxial wafer substrate can be more even. In this way, generation of defects such as black spots, blurred edges, and cracks on the flat edge of the epitaxial wafer is avoided, and the crystal quality of the flat edge of the epitaxial wafer is improved, thereby improving an overall yield of the epitaxial wafer.

An embodiment of this application provides a wafer carrier for metal organic chemical vapor deposition. As shown in FIG. 7, the wafer carrier includes at least one wafer sub-carrier 102. The wafer sub-carrier 102 is in a groove structure and is configured to place the epitaxial wafer substrate 103. The wafer sub-carrier has a side wall whose thermal conductivity is higher than a thermal conductivity of a bottom wall of the wafer sub-carrier.

The wafer carrier may be a large graphite carrier, and the wafer sub-carrier 102 is a small graphite carrier disposed on the large graphite carrier. Specifically, as shown in FIG. 4, it can be learned that the wafer sub-carrier 102 and the wafer carrier are independent of each other, and the wafer sub-carrier 102 is located on the wafer carrier. In an example, the wafer sub-carrier 102 can rotate during growth of an epitaxial wafer.

The epitaxial wafer substrate 103 may be a substrate with a diameter greater than or equal to 6 inches. Specifically, the epitaxial wafer substrate 103 may be a substrate with a diameter of 6 inches, or may be a substrate with a diameter of 8 inches, or may be a substrate with a diameter of 12 inches.

In an example, a material of the bottom wall of the wafer sub-carrier 102 may be graphite, and a material of the side wall of the wafer sub-carrier 102 is graphene.

Specifically, a structure of the wafer sub-carrier 102 may be shown in FIG. 4. The wafer sub-carrier 102 includes a bottom wall 1021 and a side wall 1022. A component material of the bottom wall 1021 is graphite, and a component material of the side wall 1022 is graphene. A surface of the bottom wall 1021 and a surface of the side wall 1022 are coated with silicon carbide, to increase strength and hardness, and to mitigate gas corrosion.

In an example, the side wall of the wafer sub-carrier includes a first layer and a second layer, and a thermal conductivity of the second layer is higher than the thermal conductivity of the bottom wall of the wafer sub-carrier.

In a case of this example, the structure of the wafer sub-carrier 102 may be shown in FIG. 5. The wafer sub-carrier 102 includes a bottom wall 1021 and a side wall. The side wall includes a first layer 10221 and a second layer 10222. The second layer 10222 is made of a second thermally conductive material attached to an inner periphery of the first layer 10221. A thermal conductivity of the second thermally conductive material is higher than the thermal conductivity of the bottom wall 1021 of the wafer sub-carrier. Specifically, the second thermally conductive material may be coated or bonded to the inner periphery of the first layer 10221, to form the second layer 10222.

Composition materials of the bottom wall 1021 and the first layer 10221 may be graphite, and a composition material of the second layer 10222 may be graphene. A surface of the bottom wall 1021, a surface of the first layer 10221, and a surface of the second layer 10222 are coated with silicon carbide, to increase strength and hardness, and to mitigate gas corrosion.

In another case of this example, the structure of the wafer sub-carrier 102 may be shown in FIG. 6. The wafer sub-carrier 102 is a groove of the wafer carrier, and the wafer sub-carrier 102 and the wafer carrier are integrated. The side wall of the wafer sub-carrier 102 includes a first layer 10221 and a second layer 10222. The first layer 10221 is a wall formed by a body of the wafer carrier. The second layer 10222 is made of a second thermally conductive material attached to an inner periphery of the first layer 10221. A thermal conductivity of the second thermally conductive material is higher than the thermal conductivity of the bottom wall 1021 of the wafer sub-carrier. Specifically, the second thermally conductive material may be coated or bonded to the inner periphery of the first layer 10221, to form the second layer 10222.

In a specific implementation of this example, the wafer carrier is a graphite carrier, the wafer sub-carrier 102 is a groove on the graphite carrier, and the second thermally conductive material is graphene. In other words, composition materials of the bottom wall 1021 and the first layer 10221 are both graphite, and a composition material of the second layer 10222 is graphene. A surface of the bottom wall 1021 and a surface of the second layer 10222 are coated with silicon carbide, to increase strength and hardness, and to mitigate gas corrosion.

In still another case of this example, referring to FIG. 7, the second layer 10222 is formed by filling a second space with a second thermally conductive material, the filled second thermally conductive material is attached to an inner periphery of the first layer, and the first layer is an original side wall of the wafer sub-carrier 102. The second layer 10221 is formed by filling the second thermally conductive material, and the second layer 10221 and the first layer together form a new side wall of the wafer sub-carrier 102. A thermal conductivity of the first layer of the wafer sub-carrier 102 is the same as the thermal conductivity of the bottom wall of the wafer sub-carrier 102, and a thermal conductivity of the second thermally conductive material is higher than the thermal conductivity of the bottom wall of the wafer sub-carrier 102, so that a thermal conductivity of the new side wall is higher than the thermal conductivity of the bottom wall. A gap between the wafer sub-carrier and the epitaxial wafer substrate is filled with the second thermally conductive material, so that the epitaxial wafer substrate is more stable in the wafer sub-carrier, thereby reducing a risk of flying pieces caused by a centrifugal force generated due to rotation of the wafer carrier or rotation of the wafer sub-carrier.

Materials of the first layer and the bottom wall may be graphite, and the second thermally conductive material may be graphene. A surface of the second layer 10222 and a surface of the bottom wall are coated with silicon carbide, to increase strength and hardness, and to mitigate gas corrosion.

In an example, as shown in FIG. 2, a first space 104 in any wafer sub-carrier 102 is filled with a first thermally conductive material. The first space 104 is a space between a flat edge of the epitaxial wafer substrate 103 and a side wall of the wafer sub-carrier 102 when the epitaxial wafer substrate 103 is placed on the wafer sub-carrier 102. A thermal conductivity of the first thermally conductive material is not lower than a thermal conductivity of the wafer sub-carrier 102. A surface that is of the first space 104 in any wafer sub-carrier 102 and that faces the flat edge of the epitaxial wafer substrate 103 is a plane. The plane is perpendicular to a radial direction of the wafer carrier. In an example, the first space 104 in any wafer sub-carrier 102 may be located on a side that is of the wafer sub-carrier 102 and that is away from a shaft hole 101.

In a first case of this example, a height of the first thermally conductive material filled in the first space 104 is not higher than a height of the side wall of the wafer sub-carrier 102.

To avoid a risk of the first thermally conductive material being thrown off due to rotation of the wafer carrier and rotation of the wafer sub-carrier 102, the height of the filled first thermally conductive material is not higher than that of the side wall of the wafer sub-carrier 202.

In a specific implementation solution of the first example, the height of the first thermally conductive material filled in the first space 104 is equal to the height of the side wall of the wafer sub-carrier 102.

In another specific implementation solution of the first example, the height of the first thermally conductive material filled in the first space 104 is not higher than the height of the side wall of the wafer sub-carrier 102, and is not lower than a thickness of the epitaxial wafer substrate 103.

In a second case of this example, a material of the wafer sub-carrier 102 is graphite, and the first thermally conductive material is any one or a combination of at least two of the following:
graphite, silicon carbide, graphene, titanium metal, and tungsten metal.

In this example, the first thermally conductive material may be coated or bonded to the first space 104. A surface of the wafer sub-carrier 102 may be coated with silicon carbide, and a surface of the first thermally conductive material filled in the first space 104 may be coated with silicon carbide. Coating silicon carbide can increase strength and hardness of the surface of the wafer sub-carrier 102 and the surface of the first thermally conductive material, and can mitigate gas corrosion.

In a third case of this example, the first thermally conductive material and the second thermally conductive material may be the same, for example, both may be graphene, and may be filled at the same time during filling, thereby improving production efficiency, and a process flow is simple.

According to the wafer carrier provided in this embodiment of this application, the thermal radiation heating effect at the position of the border of the epitaxial wafer substrate can be improved, and the temperature at the position of the border of the epitaxial wafer substrate can be compensated for, so that a temperature of the entire epitaxial wafer substrate can be more even. In this way, generation of defects such as black spots, blurred edges, and cracks on the border of the epitaxial wafer is avoided, the crystal quality of the flat edge of the epitaxial wafer is improved, and an overall yield of the epitaxial wafer is improved.

## Claims

1. A wafer carrier for metal organic chemical vapor deposition, comprising:
at least one wafer sub-carrier (102) that is in a groove structure and that is configured to place a substrate for an epitaxial wafer (103); and
wherein a thermal conductivity of a side wall (1022) of the wafer sub-carrier is higher than a thermal conductivity of a bottom wall (1021) of the wafer sub-carrier;
**characterized in that** the wafer carrier further comprises:
a first space (104) in the wafer sub-carrier (102) is filled with a first thermally conductive material, the first space (104) is a space between a flat edge of the substrate for an epitaxial wafer (103) and a side wall (1022) of the wafer sub-carrier when the substrate for an epitaxial wafer (103) is placed on the wafer sub-carrier (102), a thermal conductivity of the first thermally conductive material is not lower than a thermal conductivity of the wafer sub-carrier (102).

2. The wafer carrier according to claim 1, wherein a height of the first thermally conductive material filled in the first space (104) is not higher than a height of the side wall (1022) of the wafer sub-carrier.

3. The wafer carrier according to claim 1, wherein a material of the wafer sub-carrier (102) is graphite, and the first thermally conductive material is any one or a combination of at least two of the following:
graphite, silicon carbide, graphene, titanium metal, and tungsten metal.

4. The wafer carrier according to claim 3, wherein a surface of the wafer sub-carrier (102) is coated with silicon carbide, and a surface of the first thermally conductive material filled in the first space (104) is coated with silicon carbide.

5. The wafer carrier according to claim 1, wherein the side wall (1022) of the wafer sub-carrier comprises a first layer (10221) and a second layer (10222), and a thermal conductivity of the second layer (10222) is higher than the thermal conductivity of the bottom wall (1021) of the wafer sub-carrier.

6. The wafer carrier according to claim 5, wherein the second layer (10222) comprises a second thermally conductive material attached to an inner periphery of the first layer (10221), and a thermal conductivity of the second thermally conductive material is higher than the thermal conductivity of the bottom wall (1021) of the wafer sub-carrier.

7. The wafer carrier according to claim 1, wherein the wafer carrier (100) is a graphite carrier, and the wafer sub-carrier (102) is a groove on the graphite carrier.

8. The wafer carrier according to claim 1, wherein the wafer carrier (100) is a large graphite carrier, and the wafer sub-carrier (102) is a small graphite carrier disposed on the large graphite carrier.

## Patentansprüche

1. Waferträger zur metallorganischen chemischen Gasphasenabscheidung, umfassend:
mindestens einen Wafer-Subträger (102), der eine Nutstruktur aufweist und der dazu konfiguriert ist, ein Substrat für einen epitaktischen Wafer (103) zu platzieren; und
wobei eine Wärmeleitfähigkeit einer Seitenwand (1022) des Wafer-Subträgers höher als eine Wärmeleitfähigkeit einer Bodenwand (1021) des Wafer-Subträgers ist;
**dadurch gekennzeichnet, dass** der Waferträger ferner Folgendes umfasst:
ein erster Raum (104) in dem Wafer-Subträger (102) ist mit einem ersten wärmeleitfähigen Material gefüllt, der erste Raum (104) ist ein Raum zwischen einer flachen Kante des Substrats für einen epitaktischen Wafer (103) und einer Seitenwand (1022) des Wafer-Subträgers, wenn das Substrat für einen epitaktischen Wafer (103) auf dem Wafer-Subträger (102) platziert ist, eine Wärmeleitfähigkeit des ersten wärmeleitfähigen Materials ist nicht niedriger als eine Wärmeleitfähigkeit des Wafer-Subträgers (102).

2. Waferträger nach Anspruch 1, wobei eine Höhe des ersten wärmeleitfähigen Materials, das in den ersten Raum (104) eingefüllt ist, nicht höher als eine Höhe der Seitenwand (1022) des Wafer-Subträgers ist.

3. Waferträger nach Anspruch 1, wobei ein Material des Wafer-Subträgers (102) Graphit ist und das erste wärmeleitfähige Material eines oder eine Kombination mindestens zweier von Folgendem ist:
Graphit, Siliziumkarbid, Graphen, Titanmetall und Wolframmetall.

4. Waferträger nach Anspruch 3, wobei eine Oberfläche des Wafer-Subträgers (102) mit Siliziumkarbid beschichtet ist und eine Oberfläche des ersten wärmeleitfähigen Materials, das in den ersten Raum (104) eingefüllt ist, mit Siliziumkarbid beschichtet ist.

5. Waferträger nach Anspruch 1, wobei die Seitenwand (1022) des Wafer-Subträgers eine erste Schicht (10221) und eine zweite Schicht (10222) umfasst und eine Wärmeleitfähigkeit der zweiten Schicht (10222) höher als die Wärmeleitfähigkeit der Bodenwand (1021) des Wafer-Subträgers ist.

6. Waferträger nach Anspruch 5, wobei die zweite Schicht (10222) ein zweites wärmeleitfähiges Material umfasst, das an einem inneren Umfang der ersten Schicht (10221) angebracht ist, und eine Wärmeleitfähigkeit des zweiten wärmeleitfähigen Materials höher als die Wärmeleitfähigkeit der Bodenwand (1021) des Wafer-Subträgers ist.

7. Waferträger nach Anspruch 1, wobei der Waferträger (100) ein Graphitträger ist und der Wafer-Subträger (102) eine Nut auf dem Graphitträger ist.

8. Waferträger nach Anspruch 1, wobei der Waferträger (100) ein großer Graphitträger ist und der Wafer-Subträger (102) ein kleiner Graphitträger ist, der auf dem großen Graphitträger angeordnet ist.

## Revendications

1. Support de tranche pour dépôt chimique en phase vapeur organométallique, comprenant :
au moins un sous-support de tranche (102) qui se situe dans une structure de rainure et qui est configuré pour placer un substrat pour une tranche épitaxiale (103) ; et
dans lequel une conductivité thermique d'une paroi latérale (1022) du sous-support de tranche est supérieure à une conductivité thermique d'une paroi inférieure (1021) du sous-support de tranche ;
**caractérisé en ce que** le support de tranche comprend également :
un premier espace (104) dans le sous-support de tranche (102) occupé par un premier matériau thermoconducteur, le premier espace (104) est un espace entre un bord plat du substrat pour une tranche épitaxiale (103) et une paroi latérale (1022) du sous-support de tranche lorsque le substrat pour une tranche épitaxiale (103) est placé sur le sous-support de tranche (102), une conductivité thermique du premier matériau thermoconducteur n'est pas inférieure à une conductivité thermique du sous-support de tranche (102).

2. Support de tranche selon la revendication 1, dans lequel une hauteur du premier matériau thermoconducteur occupant le premier espace (104) n'est pas supérieure à une hauteur de la paroi latérale (1022) du sous-support de tranche.

3. Support de tranche selon la revendication 1, dans lequel un matériau du sous-support de tranche (102) est du graphite, et le premier matériau thermoconducteur est l'un quelconque ou une combinaison d'au moins deux des matériaux suivants :
du graphite, du carbure de silicium, du graphène, du titane et du tungstène.

4. Support de tranche selon la revendication 3, dans lequel une surface du sous-support de tranche (102) est revêtue de carbure de silicium, et une surface du premier matériau thermoconducteur occupant le premier espace (104) est revêtue de carbure de silicium.

5. Support de tranche selon la revendication 1, dans lequel la paroi latérale (1022) du sous-support de tranche comprend une première couche (10221) et une seconde couche (10222), et une conductivité thermique de la seconde couche (10222) est supérieure à la conductivité thermique de la paroi inférieure (1021) du sous-support de tranche.

6. Support de tranche selon la revendication 5, dans lequel la seconde couche (10222) comprend un second matériau thermoconducteur fixé à une périphérie interne de la première couche (10221), et une conductivité thermique du second matériau thermoconducteur est supérieure à la conductivité thermique de la paroi inférieure (1021) du sous-support de tranche.

7. Support de tranche selon la revendication 1, dans lequel le support de tranche (100) est un support en graphite, et le sous-support de tranche (102) est une rainure sur le support en graphite.

8. Support de tranche selon la revendication 1, dans lequel le support de tranche (100) est un grand support en graphite, et le sous-support de tranche (102) est un petit support en graphite disposé sur le grand support en graphite.
